Europäisches Patentamt

European Patent Office

Office européen des brevets

(11) Veröffentlichungsnummer: **0 220 698**
**A2**

## (12) EUROPÄISCHE PATENTANMELDUNG

(21) Anmeldenummer: **86114808.8**

(22) Anmeldetag: **24.10.86**

(51) Int. Cl.⁴: **H01L 23/04** , **H01L 23/48**

(30) Priorität: **25.10.85 DE 3538072**

(43) Veröffentlichungstag der Anmeldung:
**06.05.87 Patentblatt 87/19**

(84) Benannte Vertragsstaaten:
**DE FR GB SE**

(71) Anmelder: **Siemens Aktiengesellschaft Berlin und München**
**Wittelsbacherplatz 2**
**D-8000 München 2(DE)**

(72) Erfinder: **Bechteler, Martin, Dr.**
**Nelkenweg 10**
**D-8011 Kirchheim(DE)**
Erfinder: **Egerbacher, Werner**
**Vogelhartstrasse 4**
**D-8000 München 40(DE)**

(54) **Thyristor mit scheibenförmigem Gehäuse.**

(57) GTO-Thyristoren weisen im allgemeinen viele kleine inselförmige Emitterzonen auf. Die von den Emitterzonen nicht beanspruchte Oberfläche bildet das Basisgebiet und ist von einer Gateelektrode bedeckt. Zur Verringerung des lateralen Spannungsabfalls in der Gateelektrode wird diese durch einen Kontaktring (21) kontaktiert, der über Federn (24, 28) an die Gateelektrode angepreßt wird. Der Kontaktring sitzt zwischen dem Zentrum und dem Rand oder am Rand des Halbleiterkörpers auf der Gateelektrode auf.

FIG 1

EP 0 220 698 A2

## Thyristor mit scheibenförmigem Gehäuse

Die Erfindung bezieht sich auf einen Thyristor mit scheibenförmigem Gehäuse, bestehend aus einem Isolierring und zwei mit diesem verbundenen Deckplatten, mit einem Halbleiterkörper, der katodenseitig mit mindestens einer Gateelektrode und mit mindestens einer Katodenelektrode versehen ist, mit einem Gateanschluß, der durch Federdruck mit der Gateelektrode kontaktiert ist.

Ein solcher Thyristor ist beispielsweise in der DE-PS 22 46 423 beschrieben worden. Der Thyristor hat eine zentrale Gateelektrode, die über eine zentral angeordnete Feder kontaktiert ist. Eine solche Anordnung ist zur Steuerung konventioneller Thyristoren weit verbreitet. Bei Einspeisung eines Steuerstroms breitet sich der Zündvorgang ausgehend von der der Gateelektrode gegenüberliegenden Innenkante des Emitters nach außen aus, bis der gesamte Querschnitt des Halbleiterkörpers Strom führt.

Bei abschaltbaren Thyristoren, auch Gate-Turn-Off(GTO)Thyristoren genannt, wird das Abschalten dadurch bewirkt, daß ein der Polarität des Steuerstroms entgegengesetzter Strom aus dem Halbleiterkörper abgezogen wird. Dieser Strom ist wesentlich höher als der zum Einschalten erforderliche Strom und liegt in der Größenordnung von 1/3 bis 1/10 des Nenn-Laststroms. Fließt ein solch hoher Strom aus dem Halbleiterkörper radial zu einer zentral angeordneten Steuerelektrode, so wird unter dem katodenseitigen Emitter ein hoher Spannungsabfall erzeugt. Er kann so hoch sein, daß der Außenbereich des Emitters in Vorwärtsrichtung vorgespannt bleibt und der Thyristor nicht gesperrt wird. Steigt in diesem Zustand die Anoden-Katoden-Spannung am Thyristor wieder an, so kommt es zu einer erneuten Zündung des Thyristors.

Zur Vermeidung dieser Nachteile und zur Verringerung der Freiwerdezeit ist es bekanntgeworden, den Emitter eines GTO-Thyristors in kleine inselförmige Bereiche zu zerlegen, die lediglich über eine gemeinsame Katodenelektrode elektrisch miteinander verbunden sind. Durch die feine Struktur werden die lateralen Spannungsabfälle unter den Emitterinseln so klein gehalten, daß die Speicherladung innerhalb kurzer Zeit ausgeräumt werden kann. Das heißt, daß mit einem solchen Thyristor annehmbar kleine Freiwerdezeiten erreicht werden können. Ein Thyristor mit der erwähnten inselförmigen Struktur des Emitters ist z. B. in den "Siemens Forschungs-und Entwicklungsberichten", Band 14 (1985), Nr. 2, Seiten 39 bis 44, insbesondere Bild 4, beschrieben worden. Hierbei nimmt die Gateelektrode den von den Emitterinseln nicht beanspruchten Teil der Oberfläche des Halbleiterkörpers ein.

Da der Abschaltstrom eines solchen Thyristors verglichen mit dem Einschaltstrom relativ groß ist, kann es bei zentraler Gateelektrode zu großen Spannungsabfällen in lateraler Richtung der Gateelektrode kommen. Daher wird die Gateelektrode beim GTO-Thyristor im allgemeinen an mehreren Stellen kontaktiert. Bei dem aus der oben erwähnten Zeitschrift bekannten GTO-Thyristor bietet sich eine ringförmige Fläche der Gateelektrode an, die zwischen einem ersten und einem zweiten, dazu konzentrischen Ring von inselförmig angeordneten Emitterzonen liegt.

Der Erfindung liegt nun die Aufgabe zugrunde, einen sicheren und zuverlässigen Kontakt für einen Thyristor der eingangs erwähnten Gattung zu -schaffen, dessen Halbleiterkörper eine Gateelektrode mit mindestens einem ringförmigen Bereich aufweist.

Diese Aufgabe wird gemäß der Erfindung dadurch gelöst, daß in der katodenseitigen Deckplatte oder in einer zwischen dieser Deckplatte und dem Halbleiterkörper angeordneten metallenen Zwischenplatte auf der dem Halbleiterkörper zugewandten Seite eine ringförmige Nut vorgesehen ist,

daß in der ringförmigen Nut ein metallener Kontaktring angeordnet ist,

daß der Kontaktring gegen die Nut isoliert ist,

daß zwischen dem Boden der Nut und dem Kontaktring mindestens eine Feder sitzt, die den Kontaktring gegen die Gateelektrode drückt,

und daß der Gateanschluß elektrisch mit dem Kontaktring verbunden ist.

Weiterbildungen der Erfindung sind Gegenstand der Unteransprüche.

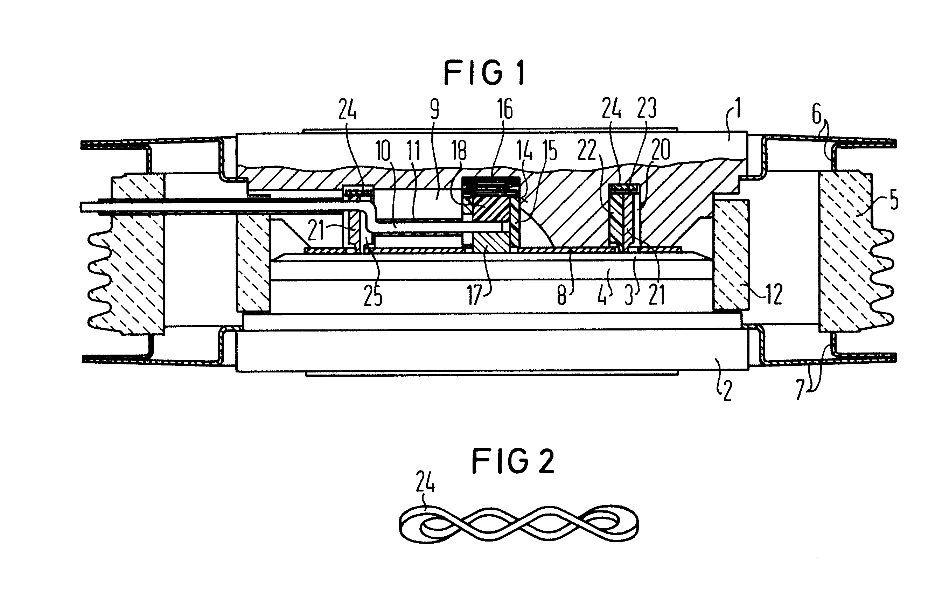

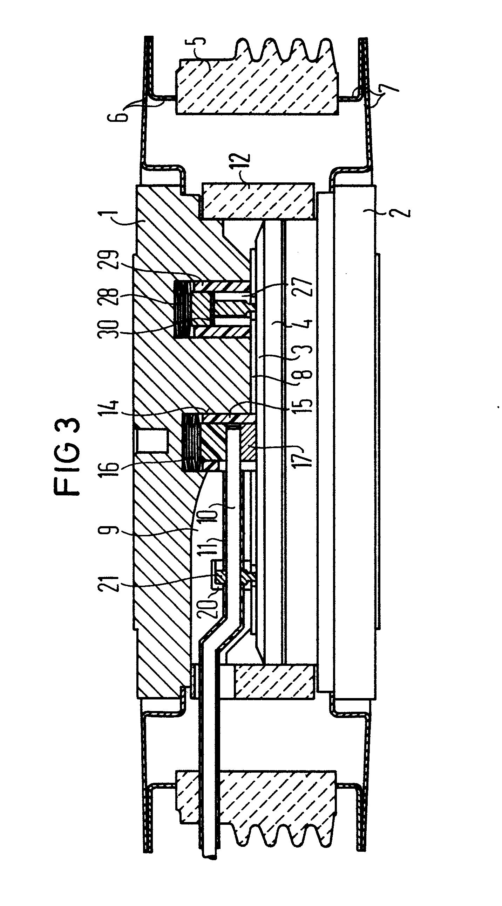

Die Erfindung wird anhand zweier Ausführungsbeispiele in Verbindung mit den Fig. 1 bis 3 näher erläutert. Dabei zeigen die Fig. 1 und 3 Schnitte durch zwei verschiedene Ausführungsbeispiele eines GTO-Thyristors und die Fig. 2 eine Einzelheit aus dem Ausführungsbeispiel nach Fig. 1.

Der Thyristor nach Fig. 1 weist eine katodenseitige Deckplatte 1 und eine anodenseitige Deckplatte 2 auf. Diese Deckplatten dienen als Zuführungselektroden. Die Deckplatten kontaktieren einen Halbleiterkörper 3, der üblicherweise auf eine Molybdänronde 4 auflegiert ist. Die Deckplatten 1, 2 sind über metallene Flansche 6, 7 mit einem Isolierstoffring 5 verbunden. Dieser besteht im allgemeinen aus Keramik.

Die Katodenelektrode des Halbleiterkörpers 3 ist mit 8 bezeichnet. Die Gateelektrode ist der besseren Übersichtlichkeit halber nicht dargestellt, sie fällt zeichnerisch mit der katodenseitigen Oberfläche des Halbleiterkörpers 3 zusammen.

Die Gateelektrode ist an einer zentralen Stelle des Halbleiterkörpers 3 durch eine metallene Kontaktscheibe 17 kontaktiert. Diese Kontaktscheibe sitzt in einer Sackbohrung 14 der katodenseitigen Deckplatte 1. Gegen die Deckplatte ist die Kontaktscheibe 17 durch eine Isolierhülse 15 isoliert. Die Kontaktscheibe 17 wird durch eine oder mehrere Federn 16 an den zentralen Teil der Gateelektrode angepreßt. Die Federn 16 stützen sich dabei gegen den Boden der Sackbohrung 14 ab. Zur Isolierung der Kontaktscheibe 17 gegen die Deckplatte 1 liegt zwischen den Federn 16 und der Kontaktscheibe 17 ein Isolierstoffplättchen 18.

Die Kontaktscheibe 17 ist mit einer radialen Bohrung versehen, in der ein Gateanschluß 10 z. B. durch Verlöten befestigt ist. Der Gateanschluß 10 ist über einen Teil seiner Länge mit einer Isolierstoffhülse 11 überzogen und führt durch einen Schlitz 9 in der Deckplatte 1 und eine radiale Öffnung des Isolierstoffrings 5 nach außen.

In der katodenseitigen Deckplatte 1 ist eine ringförmige Nut 20 vorgesehen, in der ein metallener Kontaktring 21 sitzt. Dieser Kontaktring sitzt auf einem ringförmigen Teil der Gateelektrode auf. Dieser ringförmige Teil kann am Rand des Halbleiterkörpers oder zwischen Rand und Zentrum des Halbleiterkörpers liegen. Der Kontaktring 21 wird durch einen in der Nut 20 angeordneten konzentrischen Isolierstoffring 22 zentriert. Dieser Ring kann, wie dargestellt, innerhalb des Kontaktrings 21 oder außerhalb angeordnet sein. Zwischen dem Boden der Nut 20 und dem Kontaktring 21 bzw. dem Zentrierring 22 ist eine Feder 24 angeordnet, die den Kontaktring gegen einen ringförmigen Bereich der Gateelektrode preßt. Als Feder kommt hier vorzugsweise eine mehrfach gewellte Federscheibe in Betracht, wie sie in Fig. 2 gezeigt ist. Es ist auch möglich, eine ringförmige Tellerfeder zu verwenden. Zwischen der Federscheibe 24 und dem Kontaktring 21 liegt zur Isolation des Kontaktrings gegen die Deckplatte 1 eine ringförmige Isolierfolie 23. Die Anordnung nach Fig. 1 wurde so geschnitten, daß die Federscheibe 24 auf der rechten Seite am Boden der Nut 20 anliegt, auf der linken Seite jedoch am Kontaktring 21. Im Extremfall kann die Federscheibe 24 völlig plan verformt werden.

Im Ausführungsbeispiel nach Fig. 1 ist der Gateanschluß 10 elektrisch mit dem Kontaktring 21 verbunden. Es ist jedoch auch möglich, die Kontaktscheibe 17 und den Kontaktring 21 über je einen besonderen Gateanschluß nach außen zu führen. Für beide Fälle weist der Isolierstoffring 22 einen Schlitz 25 auf, durch den der Gateanschluß hindurchgeht.

Das Ausführungsbeispiel nach Fig. 3 unterscheidet sich von dem nach Fig. 1 im wesentlichen durch eine andere Anordnung der für das Anpressen des Kontaktrings 21 bestimmten Federn. Hier sind über den Umfang des Kontaktrings 21 verteilte Federn 28 angeordnet. Diese belasten den Kontaktring über ein Druckstück 30, das gegen den Kontaktring durch eine Isolierfolie 21 isoliert ist. Zweckmäßigerweise sitzen die Federn 28 jeweils in einem Sackloch 27, dessen Durchmesser dem Federdurchmesser entspricht.

Der Kontaktring 21 und die Kontaktscheibe 17 sind wiederum mit einem Gateanschluß 10 verbunden.

In den Ausführungsbeispielen ist die ringförmige Nut 20 in der katodenseitigen Deckplatte 1 angeordnet. Sie kann jedoch auch in einer metallenen Zwischenplatte liegen, die zwischen dem Halbleiterkörper und der Deckplatte 1 angeordnet ist.

Bezugszeichenliste

    1, 2 = Deckplatte
    3 = Halbleiterkörper
    4 = Molybdänronde
    5 = Isoloerstoffring
    6, 7 = Flansch
    8 = Katodenelektrode
    9 Schlitz
    10 = Gateanschluß
    11 = Isolierstoffhülse
    14 = Sackbohrung
    15 = Isolierhülse
    16 = Feder
    17 = Kontaktscheibe
    18 = Isolierstoffplättchen
    20 = Nut
    21 = Kontaktring
    22 = Isolierstoffring
    23 = Isolierfolie
    24 = Feder
    25 = Schlitz
    27 = Sackloch
    28 = Feder
    30 = Druckstück

**Ansprüche**

1. Thyristor mit scheibenförmigem Gehäuse, bestehend aus einem Isolierring und zwei mit diesem verbundenen Deckplatten, mit einem Halbleiterkörper, der katodenseitig mit mindestens einer Gateelektrode und mit mindestens einer Katodenelektrode versehen ist, mit einem Gateanschluß, der durch Federdruck mit der Gateelektrode kontaktiert ist, **dadurch gekennzeichnet,**

daß in der katodenseitigen Deckplatte (1) oder in einer zwischen dieser Deckplatte und dem Halbleiterkörper (3) angeordneten metallenen Zwischenplatte auf der dem Halbleiterkörper zugewandten Seite eine ringförmige Nut (20) vorgesehen ist,

daß in der ringförmigen Nut (20) ein metallener Kontaktring (21) angeordnet ist,

daß der Kontaktring (21) gegen die Nut isoliert ist, daß zwischen dem Boden der Nut (20) und dem Kontaktring mindestens eine Feder (24, 28) sitzt, die den Kontaktring gegen die Gateelektrode drückt,

und daß der Gateanschluß (10) elektrisch mit dem Kontaktring verbunden ist.

2. Thyristor nach Anspruch 1, **dadurch gekennzeichnet,** daß zwischen dem Boden der Nut - (20) und dem Kontaktring (21) über den Umfang der Nut verteilt mehrere Druckfedern (28) angeordnet sind.

3. Thyristor nach Anspruch 1, **dadurch gekennzeichnet,** daß zwischen dem Boden der Nut und dem Kontaktring eine mehrfach gewellte Federscheibe (24) angeordnet ist.

4. Thyristor nach Anspruch 1, **dadurch gekennzeichnet,** daß der Kontaktring (21) durch einen konzentrischen Isolierstoffring (22) in der Nut - (20) zentriert ist.

5. Thyristor nach einem der Ansprüche 1 bis 4, **dadurch gekennzeichnet,** daß in der katodenseitigen Deckplatte (1) oder der zwischen dieser Deckplatte und dem Halbleiterkörper angeordneten metallenen Zwischenplatte auf der dem Halbleiterkörper zugewandten Seite ein zentrales Sackloch (14) vorgesehen ist, daß in dem Sackloch eine Kontaktscheibe (17) angeordnet ist,

daß die Kontaktscheibe gegen das Sackloch isoliert ist, daß zwischen dem Boden des Sacklochs und der Kontaktscheibe mindestens eine Feder (16) sitzt, die die Kontaktscheibe gegen die Gateelektrode drückt, und daß die Kontaktscheibe elektrisch mit einem Gateanschluß (10) verbunden ist.

6. Thyristor nach Anspruch 5, **dadurch gekennzeichnet** , daß zwei Gateanschlüsse vorgesehen sind, die durch das Gehäuse nach außen geführt sind und daß der Kontaktring (21) mit dem einen und die Kontaktscheibe (17) mit dem anderen Gateanschluß verbunden ist.

7. Thyristor nach Anspruch 5, **dadurch gekennzeichnet,** daß ein einziger Gateanschluß (10) vorgesehen ist, der durch das Gehäuse nach außen geführt ist und daß der Kontaktring (21) und die Kontaktscheibe (17) mit diesem Gateanschluß - (10) verbunden sind.

FIG 1

FIG 2

# FIG 3

0 220 698